(19) Europäisches Patentamt
European Patent Office
Office européen des brevets

(11) **EP 2 534 499 B1**

(12) **FASCICULE DE BREVET EUROPEEN**

(45) Date de publication et mention
de la délivrance du brevet:
**08.04.2015 Bulletin 2015/15**

(51) Int Cl.:
*G01R 33/34* *(2006.01)* *G01R 33/36* *(2006.01)*
*G01R 33/422* *(2006.01)* *G01R 33/345* *(2006.01)*
*H01P 5/10* *(2006.01)* *G01N 24/08* *(2006.01)*
*G01R 33/3415* *(2006.01)*

(21) Numéro de dépôt: **11708065.5**

(22) Date de dépôt: **07.02.2011**

(86) Numéro de dépôt international:
**PCT/FR2011/050241**

(87) Numéro de publication internationale:
**WO 2011/098713 (18.08.2011 Gazette 2011/33)**

(54) **RESONATEUR LINEAIRE D'UNE ANTENNE HAUTE FREQUENCE POUR APPAREIL D'IMAGERIE PAR RESONANCE MAGNETIQUE NUCLEAIRE**

LINEARRESONATOR EINER HR-ANTENNE FÜR EIN KERNMAGNETRESONANZBILDGEBUNGSERÄT

LINEAR RESONATOR OF A HIGH-FREQUENCY ANTENNA FOR A NUCLEAR MAGNETIC RESONANCE IMAGING APPARATUS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.02.2010 FR 1050905**

(43) Date de publication de la demande:
**19.12.2012 Bulletin 2012/51**

(73) Titulaire: **Commissariat à l'Énergie Atomique et aux Énergies Alternatives 75015 Paris (FR)**

(72) Inventeurs:
• **FERRAND, Guillaume**
  **F-75014 Paris (FR)**
• **LUONG, Michel**
  **F-92330 Sceaux (FR)**
• **FRANCE, Alain**
  **F-33200 Bordeaux (FR)**

(74) Mandataire: **Lebkiri, Alexandre Cabinet Camus Lebkiri 25, Rue de Maubeuge 75009 Paris (FR)**

• **ADRIANY G ET AL: "A geometrically adjustable 16 Channel Transceive Transmission Line Array for 7 Tesla", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, vol. 13, 1 janvier 2005 (2005-01-01), page 673, XP002472561, ISSN: 1524-6965**
• **TIAN J ET AL: "Frequency limits and radiation resistance for volume coils", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, vol. 11, 10 juillet 2003 (2003-07-10), page 2354, XP007914507, ISSN: 1524-6965 cité dans la demande**
• **SETSOMPOP K ET AL: "Parallel RF transmission with eight channels at 3 Tesla", MAGNETIC RESONANCE IN MEDICINE, ACADEMIC PRESS, DULUTH, MN, US LNKD- DOI:10.1002/MRM. 21042, vol. 56, no. 5, 1 novembre 2006 (2006-11-01), pages 1163-1171, XP002513112, ISSN: 0740-3194 cité dans la demande**

(56) Documents cités:
**US-A- 4 746 866     US-A- 4 751 464
US-A- 5 557 247     US-A1- 2005 062 472**

- ADRIANY GREGOR ET AL: "Transmit and receive transmission line arrays for 7 Tesla parallel imaging", MAGNETIC RESONANCE IN MEDICINE, ACADEMIC PRESS, DULUTH, MN, US LNKD- DOI:10.1002/MRM.20321, vol. 53, no. 2, 1 février 2005 (2005-02-01), pages 434-445, XP002495549, ISSN: 0740-3194 cité dans la demande

- YARNYKH V L: "Actual flip-angle imaging in the pulsed steady state: A method for rapid three-dimensional mapping of the transmitted radiofrequency field", MAGNETIC RESONANCE IN MEDICINE, ACADEMIC PRESS, DULUTH, MN, US LNKD- DOI:10.1002/MRM.21120, vol. 57, 1 janvier 2007 (2007-01-01), pages 192-200, XP002530750, ISSN: 0740-3194 [extrait le 2006-12-26] cité dans la demande

**EP 2 534 499 B1**

**Description**

La présente invention concerne un résonateur linéaire d'une antenne haute fréquence à voies multiples en réception et/ou en transmission, utilisée en particulier dans les appareils de Résonance Magnétique Nucléaire (RMN), ainsi que leurs applications : Imagerie par Résonance Magnétique (IRM) pour l'homme ou l'animal, Spectroscopie par Résonance Magnétique (SRM), ou encore imagerie du tenseur de diffusion.

Le domaine de l'invention est celui de la Résonance Magnétique Nucléaire (RMN), incluant les applications ci-dessus.

L'invention s'applique particulièrement à des antennes haute fréquence à voies multiples en réception et en transmission utilisées pour l'examen d'un corps humain entier ou uniquement d'une partie du corps, comme par exemple une tête, dans des appareils RMN et plus particulièrement dans les appareils d'Imagerie par Résonance Magnétique (IRM) à très haut champ magnétique, c'est-à-dire au-delà de 7 Tesla. Ces appareils ont pour fonction d'exciter les spins magnétiques des atomes d'hydrogène de l'échantillon placé à l'intérieur de l'antenne, et de recueillir le signal de radiofréquence qu'ils émettent lors de la relaxation exposée ci-après.

D'une façon connue, les antennes des appareils d'IRM sont formées par des éléments rayonnants en cuivre, de formes variables, jouant soit le rôle de bobinages émetteurs, en résonance avec le circuit qui l'alimente, soit le rôle de récepteurs de signaux de relaxation, soit plus généralement ces deux fonctions alternativement. Elles entourent le patient ou seulement la partie du corps à analyser.

Placées dans le champ magnétique longitudinal permanent $B_0$, d'un dispositif de RMN, elles reçoivent une excitation électrique leur permettant de produire le champ magnétique $B_1$ orthogonal à $B_0$, et/ou captent le signal de radiofréquence (RF) qui correspond à la fréquence de résonance de précession ou de relaxation (également appelée fréquence de Larmor) des noyaux des atomes étudiés qui se trouvent dans le champ magnétique $B_0$ et ont été momentanément soumis au champ magnétique $B_1$.

On rappelle que sous l'effet du champ magnétique statique $B_0$, les moments magnétiques de spin des noyaux d'atomes d'hydrogène vont progressivement s'aligner dans une direction initialement parallèle au champ magnétique $B_0$ et donner lieu à une aimantation globale dans la direction du champ $B_0$, dite direction longitudinale z.

Lorsqu'on applique une excitation sous forme d'une impulsion, c'est-à-dire un champ radiofréquence oscillant à la fréquence de Larmor ayant une composante magnétique notée $B_1$, perpendiculaire à $B_0$, les moments magnétiques de spin vont alors résonner et s'écarter progressivement de cet axe longitudinal z pour aller se placer à un angle de bascule noté FA par rapport à cet axe de départ en décrivant un mouvement, appelé mouvement de précession. Le champ radiofréquence $B_1$ permet donc de faire « basculer » les moments magnétiques de spin sur un angle FA par rapport à la direction du champ $B_0$.

Lorsque l'excitation est interrompue, les moments magnétiques de spin qui se sont écartés de leur axe initial reviennent vers leur position d'équilibre, c'est-à-dire l'axe z, sans cesser de tourner. Ce retour à l'équilibre est appelé relaxation. Il est alors possible de mesurer ce mouvement de rotation des spins sous la forme d'un champ radiofréquence très faible capté par l'antenne, le champ radiofréquence capté ayant la même fréquence que le champ radiofréquence excitateur, c'est-à-dire la fréquence de résonance de Larmor.

Les antennes selon l'invention sont destinées à rayonner le champ magnétique impulsionnel B1, ou à recevoir les signaux générés par la relaxation des noyaux d'atomes d'hydrogène, et préférentiellement à effectuer ces deux fonctions à des moments successifs.

De façon particulière, les antennes utilisées pour l'examen d'une partie du corps et en particulier de la tête, sont des antennes fonctionnant en champ magnétique proche, c'est-à-dire près des éléments physiques rayonnants.

En conséquence, dans ce type d'antenne, la « charge », c'est à dire la tête ou une autre partie du corps du patient, introduite dans l'antenne rétroagit sur le champ radiofréquence proche de l'antenne. Ainsi, l'introduction d'une charge dans une antenne d'IRM modifie significativement la fréquence d'accord et l'impédance de l'antenne déterminées préalablement.

De plus, une tête humaine présente d'un point de vue radioélectrique une impédance très irrégulière qui génère de nombreux artéfacts.

D'une façon classique, les intensités de champ magnétique $B_0$ utilisées en imagerie médicale sont comprises entre 0,1 et 3 Tesla. A ces faibles intensités de champ magnétique, la fréquence de fonctionnement, correspondant à la fréquence de Larmor, reste faible. A titre d'exemple, pour un champ magnétique $B_0$ de 1,5 Tesla, la fréquence de Larmor correspondante est de 64 MHz et pour un champ magnétique $B_0$ de 3 Tesla, la fréquence de Larmor correspondante est de 128 MHz.

Jusqu'à 128 MHz, les antennes utilisées sont des structures de type cavité résonante. Ce type d'antenne est connu sous les dénominations cage à oiseau (en anglais birdcage) ou TEM (pour Traverse Electric and Magnetic en langue anglaise) et comprend :

- un ensemble de lignes de transmission couplées entre elles pour créer un mode de résonance ;

- un blindage qui entoure cet ensemble de lignes de transmission, et
- deux ou quatre ports de connexion (« RF ports » en langue anglaise) qui sont intercalés entre l'ensemble de lignes de transmission et le blindage et qui sont destinés à l'excitation radiofréquence de la cavité résonante et à la détection des signaux de radiofréquence RMN.

Ce type d'antenne est notamment décrit dans les documents suivants :

[1] US 4746866 (Röschmann)
[2] US 4751464 (Bridges)
[3] US 5557247 (Vaughn, Jr.)
[4] Proc. Int. Soc. Mag. Res. Med. 11, 2003, N°2354 (Vaughn).

Ces documents concernent essentiellement des améliorations apportées aux lignes de transmissions d'une cavité résonante et décrivent notamment les moyens pour accorder (« tune » en langue anglaise) chaque ligne de transmission à la fréquence de travail souhaitée qui sont formés généralement par des moyens mécaniques de réglage de couplage électromagnétique entre les lignes de transmission et le blindage.

Ainsi, le document [1] divulgue une antenne, appelée également bobine, qui est destinée à un appareil d'IRM et qui est formée par des lignes de transmission qui s'apparentent à des câbles coaxiaux. Chacune des lignes de transmission comporte un cylindre externe, creux et conducteur, contenant un cylindre interne creux réalisé dans un matériau diélectrique et à l'intérieur duquel sont placés deux conducteurs centraux dont au moins l'un de ces derniers est mobile axialement.

Un blindage externe est couplé aux conducteurs centraux par l'intermédiaire des extrémités du cylindre externe, grâce notamment à des contacts glissants.

Le document [2] décrit une cavité résonante dont les lignes de transmission sont formées par des segments de bandes conductrices, entre lesquels sont intercalées des sections d'un matériau diélectrique. Un blindage externe est couplé aux lignes de transmission par l'intermédiaire de capacités qui sont situées aux extrémités de chaque ligne de transmission. L'accord (« tune ») de la cavité résonante est effectué au moyen de fentes réglables formées dans le blindage externe. Dans le document [2], les « barreaux » se présentent sous la forme de rubans de section rectangulaire. D'autre part, la surface principale des éléments diélectriques est parallèle à l'axe du barreau. Les barreaux (ou rubans) sont des éléments fixes ne permettant aucun ajustement. Enfin, la liaison d'un barreau avec l'enveloppe est isolante.

Le document [3] utilise des lignes de transmission, qui s'apparentent à des câbles coaxiaux tels que décrits dans le document [1], pour former une cavité résonante de type cage à oiseau. En outre, ce document décrit un système mécanique permettant d'accorder simultanément plusieurs lignes de transmission.

Les cavités résonnantes connues, décrites par les documents cités, présentent l'inconvénient de ne pas fonctionner convenablement lorsqu'on les utilise à des valeurs élevées de champ magnétique, c'est-à-dire au-delà de 7 Tesla et/ou au-delà de fréquence élevée de l'ordre de 298 MHz, en vue d'augmenter le rapport signal/bruit. En effet, jusqu'à 3 Tesla, la fréquence de Larmor correspondante reste faible et les artefacts sont tolérables, ce qui permet d'obtenir une image qualitative de la zone étudiée.

Par exemple, des expériences et une simulation numérique du résonateur décrit dans le document [4] par la méthode des éléments finis montrent qu'un tel résonateur est limité à des fréquences de résonance du proton (fréquence de Larmor) qui sont inférieures à environ 400 MHz, ou à des champs magnétiques inférieurs à 4 Tesla, pour des volumes cylindriques de 27 cm de diamètre et de 25 cm de long, de tels volumes correspondant à des volumes utiles aptes à recevoir une tête humaine.

En effet, pour augmenter la fréquence, les conducteurs centraux des lignes de transmission doivent être complètement retirés ce qui provoque des pertes par rayonnements ainsi qu'une mauvaise homogénéité du champ B1 produit.

Ainsi, lorsque les fréquences de Larmor sont supérieures à 128 MHz, les antennes de type volumique et fonctionnant en mode quadrature, décrites précédemment, commencent à montrer leur limite en terme d'homogénéité de l'excitation des protons.

En effet, le champ magnétique $B_1$ se trouve perturbé dès l'introduction de la tête du sujet. Il en résulte des artéfacts importants rendant l'utilisation de ces antennes pratiquement inutilisables à des valeurs de champs magnétiques élevées, c'est-à-dire supérieures à 7 Tesla. Or, il est utile, notamment dans le cadre d'imagerie médicale, de pouvoir obtenir une image qualitative reflétant fidèlement la nature des tissus du sujet analysé. Par conséquent, il est nécessaire de disposer d'une antenne haute fréquence apte à proposer une répartition homogène de l'excitation des protons qui ne soit pas perturbée par l'introduction d'une « charge » à l'intérieur de l'antenne dans ces conditions de champ magnétique élevé.

Pour ces fréquences supérieures à 128 MHz, il a été développé des antennes de type réseau formées par une répartition d'une pluralité de résonateurs, généralement entre 8 et 32, servant d'émetteurs et de récepteurs et qui sont repartis autour de l'échantillon à mesurer.

Chaque résonateur comporte une voie, ou canal, de pilotage propre pour l'émission et la réception du signal radiofréquence. Chaque résonateur permet ainsi de produire une image de la région anatomique en regard de laquelle elle se trouve. Les différentes images sont ensuite combinées par des algorithmes pour former l'image finale.

On connaît deux familles d'antenne de type réseau :

- les antennes comportant des résonateurs linéaires constitués par des feuillards de cuivre rectilignes intégrés dans un corps isolant selon la technique des micro-rubans (ou « microstrip » en langue anglaise) et généralement appelée à tort « antenne strip-line », et
- les antennes comportant des résonateurs boucles, souvent constitués d'un feuillard en cuivre collé sur un corps isolant souvent souple et appliqué directement sur l'échantillon à analyser.

Afin d'exploiter convenablement ce type d'antenne réseau, il convient de piloter chaque résonateur via son canal propre avec une amplitude et une phase appropriée au moyen d'un amplificateur de puissance. Ainsi, il devient possible de contrôler spatialement l'excitation des protons en IRM autour de l'échantillon à mesurer.

Cette technique connue, dite de transmission parallèle, permet en particulier d'homogénéiser l'excitation dans une région d'intérêt choisie, dite zone ROI (pour « Region Of Interest » en langue anglaise).

Les deux documents suivants présentent respectivement les deux familles d'antennes réseau ainsi que la technique de transmission parallèle :

[5] Magnetic Resonance in Medicine 53:434445, 2005 (Adriany),
[5a] US 2005/0062472 (Bottomley)
[6] Magnetic Resonance in Medicine 56:11631171, 2006 (Setsompop).

Les résonateurs linéaires décrits dans le document [5] sont réalisés par un collage de rubans ou de feuillards de cuivre adhésifs sur un corps en Téflon (polytétrafluoréthylène). Le ruban de cuivre porteur du courant générant le champ électromagnétique rayonné possède une largeur de 12 mm et une longueur de 160 mm. Le ruban de cuivre est alimenté par une des deux extrémités à travers un circuit d'accord en fréquence (« tuning » en langue anglaise) et d'adaptation en impédance (« matching » en langue anglaise) et présente des caractéristiques d'un résonateur quart d'onde ; le champ électromagnétique rayonné varie fortement d'une extrémité à l'autre. Par ailleurs, le circuit d'accord en fréquence et d'adaptation en impédance composé de capacités et d'inductances localisées de dimensions finies, de faible facteur de qualité, est inévitablement source de perte et d'interaction non négligeable avec le ruban rayonnant.

Enfin, la simplicité de cette implémentation n'autorise pas la mise en place d'un dispositif d'isolation passif (blindage) pour réduire le couplage mutuel entre les émetteurs/récepteurs dont l'effet se traduit par une perte de rendement en émission et une dégradation du rapport signal/bruit en réception.

Le document [5a] divulgue des antennes comportant des résonateurs similaires à ceux du document [5].

Le document [6] fournit également une description des antennes en réseau constituées de boucles formées par deux rubans disposés en vis-à-vis de part et d'autre de la paroi d'un cylindre en Téflon. Les boucles se referment sur des capacités localisées qui permettent de régler l'accord en fréquence de la boucle dans une région de très petite dimension, couramment appelée interstice (ou « gap » en langue anglaise). Cette région de l'antenne est aussi l'endroit où se réalise la connexion de chaque boucle vers l'extérieur au travers d'un circuit de « matching » analogue à celui utilisé pour les antennes linéaires.

Le principal avantage des boucles réside dans une plus grande uniformité du champ rayonné par chaque élément. Par contre, leur géométrie tend à induire un couplage mutuel important entre les émetteurs et les récepteurs, qu'il est souvent nécessaire de réduire en introduisant un couplage capacitif dont l'efficacité n'est optimale que pour une charge ou un échantillon donné.

Enfin, les performances des boucles de ce type d'antenne diminuent rapidement avec l'augmentation de la fréquence de fonctionnement.

D'une façon générale, de façon à réduire au maximum la capacité parasite constituée par l'échantillon à analyser, comme par exemple la tête du patient, l'expérience montre que les antennes de type « microstrip » de forte capacité sont privilégiées aux antennes à faible capacité devant lesquelles la capacité parasite sera trop importante.

Les réglages de « tuning » et de « matching » de ce type d'antenne « microstrip » sont difficiles à réaliser notamment à cause de la variation d'impédance créée par la proximité d'une impédance parasite telle que la main de l'opérateur lors du réglage de la fréquence et d'adaptation d'impédance de l'antenne.

Ainsi, les antennes de type réseau connues ne permettent pas de s'adapter précisément à la charge introduite dans l'antenne, ce qui a pour conséquence une non homogénéité de l'excitation des protons sur l'échantillon et donc une image non qualitative.

Dans ce contexte, la présente invention vise à résoudre les problèmes mentionnés précédemment en proposant un résonateur linéaire d'une antenne haute fréquence à voies multiples en réception et en transmission apte à opérer à une fréquence supérieure à 128 MHz tout en proposant un réglage de la fréquence de résonance et d'adaptation d'impédance permettant d'uniformiser de façon précise l'excitation des protons pour chaque charge introduite dans l'antenne.

A cette fin, l'invention propose un résonateur linéaire tel que défini par la revendication 1, qui a été délimité par rapport au document [5a].

Pour rappel un circuit « balun » désigne un circuit réalisant l'adaptation entre une ligne symétrique ou équilibrée, comme par exemple une ligne bifilaire non relié à la masse, et une ligne asymétrique, comme un câble coaxial dont l'un de ses connecteurs est relié à la masse.

Ainsi, grâce aux résonateurs linéaires selon l'invention, on obtient une antenne haute fréquence dont l'adaptation d'impédance de chaque résonateur est paramétrable lors de la conception de façon à correspondre au type de charge qui sera introduite dans l'antenne, c'est-à-dire la tête ou autre partie du corps.

L'adaptation en impédance (« matching ») du résonateur est réalisée principalement par le choix de la distance séparant les deux contacts du circuit balun sur l'élément rayonnant lors de la conception du résonateur. Les deux points de contact sont formés par les deux extrémités des lignes de couplage débouchant du substrat. Ainsi, les lignes de couplage et les points de contact sur l'élément rayonnant permettent de générer un champ magnétique colinéaire au plan de masse supérieur du résonateur par couplage magnétique. Ainsi, les surtensions dans le résonateur sont minimisées ce qui permet d'éviter une dissipation indésirable de puissance.

L'adaptation de l'impédance du résonateur est également dépendant des dimensions du circuit balun qui est incorporé dans le substrat, c'est-à-dire des dimensions de la ligne d'alimentation et des lignes de couplages.

On entend par les termes « incorporé dans le substrat » le fait que le circuit balun est enterré à l'intérieur du substrat et de sorte que le substrat recouvre entièrement le circuit balun.

Selon un mode avantageux de l'invention, les résonateurs selon l'invention comportent également des moyens de réglage permettant d'ajuster plus précisément l'adaptation d'impédance déterminée lors de la conception du résonateur et la fréquence de résonance de l'antenne afin de l'adapter à chaque résistivité propre de chaque tête. Ainsi, il est possible par exemple de régler chaque résonateur de l'antenne de façon à ce que l'antenne présente une fréquence d'excitation homogène quel que soit le type de charge introduite dans l'antenne.

Selon ce mode avantageux, les moyens de réglage d'adaptation d'impédance et de fréquence de résonance sont déportés de l'élément rayonnant et placés à une distance arbitraire, suffisamment éloigné de celui-ci, pour minimiser les interactions par rayonnement et les variations d'adaptation d'impédance par « effet de main » lors de l'opération d'ajustement d'adaptation d'impédance et de fréquence par l'opérateur.

La position éloignée des moyens de réglage est rendu possible par le fait que le circuit balun est incorporé à l'intérieur du substrat, et par le fait que le circuit balun apporte l'énergie aux deux points de contact de l'élément rayonnant par les lignes de couplage qui sont séparées de l'élément rayonnant par un plan de masse suffisamment large pour supprimer toute possibilité d'interaction.

De plus, les moyens de réglages déportés permettent de faciliter l'accès de l'opérateur aux moyens de réglages. Ainsi, les réglages se réalisent rapidement et sans contrainte en cours d'analyse.

Grâce aux résonateurs selon l'invention, on obtient une antenne réseau capable de faire des images entre 200MHz et 600Mhz, de présenter un diamètre utile supérieur à 250mm et dont chaque résonateur linéaire est ajusté indépendamment pour la transmission d'un signal radiofréquence d'excitation.

Ainsi, grâce au réglage d'adaptation d'impédance spécifique à chaque tête, la puissance d'émission des résonateurs est réduite et le rapport signal/bruit (S/N pour Signal to Noise en langue anglaise) en réception est augmenté.

Le résonateur selon l'invention peut également présenter différentes caractéristiques ainsi que défini par les revendications 2 à 14.

L'invention a également pour objet une antenne haute fréquence pour appareil de résonance magnétique nucléaire telle que définie par la revendication 15.

L'antenne selon l'invention peut également présenter différentes caractéristiques ainsi que défini par les revendications 16 à 19.

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 illustre une vue d'ensemble d'un modèle anatomique et d'une antenne haute fréquence d'IRM comportant des résonateurs linéaires selon l'invention ;
- la figure 2 illustre une vue éclatée du premier mode de réalisation du résonateur linéaire illustré à la figure 1 :
- la figure 3 illustre une vue assemblée du premier mode de réalisation du résonateur linéaire illustré aux figures 1 et 2 comportant un coupe partielle longitudinale ;
- la figure 4 est un graphique représentant la fréquence de résonance chaque résonateur linéaire de l'antenne illustré aux figures 1, et 3 avant le paramétrage des résonateurs au moyen d'un circuit « tuning » et du circuit « matching » ;
- la figure 5 est un graphique représentant la fréquence de résonance de chaque résonateur linéaire de l'antenne après paramétrage des résonateurs au moyen du circuit « tuning » et du circuit « matching » ;

- la figure 6 illustre une coupe axiale de l'antenne haute fréquence d'IRM comportant le modèle anatomique représentant un exemple de répartition du champ $B_1^+$ rayonné pour chaque résonateur linéaire ;
- la figure 7 représente un exemple d'imagerie sélective obtenue au moyen d'une antenne haute fréquence comportant des résonateurs linéaires selon l'invention ;
- la figure 8 représente un deuxième mode de réalisation d'un résonateur linéaire selon l'invention.

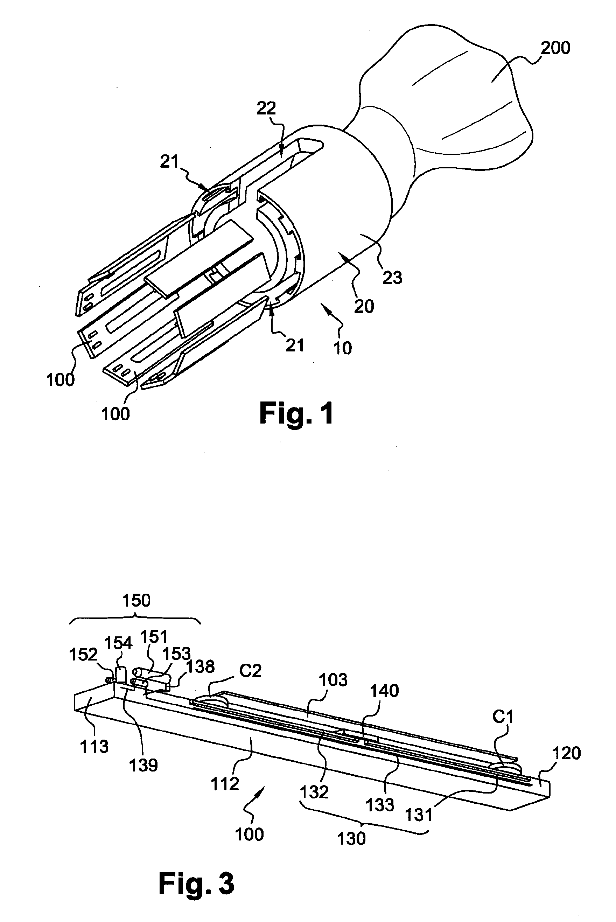

La figure 1 illustre une vue d'ensemble d'un modèle anatomique et d'une antenne haute fréquence d'IRM comportant des résonateurs linéaires selon l'invention.

L'antenne 10 est une antenne haute fréquence à voies multiples utilisée dans un appareil d'Imagerie par Résonance Magnétique (IRM), à très haut champ magnétique, c'est-à-dire au-delà de 7 Tesla. L'antenne 10 représentée est particulièrement adaptée pour l'examen d'une tête d'humain représenté à la figure 1 par un modèle anatomique 200.

L'antenne 10 comporte un corps isolant 20 de forme cylindrique comportant une pluralité de logements 21 répartis de façon circonférentielle, en périphérie du corps isolant 20, dans lesquels viennent s'insérer par l'arrière, c'est-à-dire du coté opposé à celui où l'on introduit le patient, des résonateurs linéaires 100.

D'une façon connue, le corps isolant 20 de l'antenne 10 comporte également une lumière 22 pratiquée sur la paroi latérale extérieure 23 du corps isolant 20 permettant le montage de divers systèmes de miroir destinés à la stimulation visuelle des patients dans les applications d'IRM fonctionnelles.

Le corps isolant 20 est réalisé en une seul pièce ou par l'assemblage de pièces usinées réalisées en matériau polymère, tel que par exemple du polyoxyméthylène, également appelé polyformaldéhyde, et plus connu sous la dénomination « POM ». L'utilisation du POM est particulièrement avantageux et adaptée à cette application car il comporte une bonne isolation électrique et une faible constante diélectrique ($\varepsilon_r$ = 3,7).

Selon un mode avantageux de l'invention, les parois internes, excepté celle en regard de l'élément rayonnant, des logements 21 pratiqués dans le corps isolant 20 pour loger les résonateurs 100 sont métallisées en vue d'assurer une isolation optimum entre chaque résonateur 100. L'augmentation de l'isolation entre chaque résonateur permet ainsi de réduire le couplage mutuel, c'est-à-dire le transfert de puissance entre un résonateur alimenté, ou un groupe de résonateurs groupés et reliés par une même source, et un résonateur voisin, ou groupe de résonateurs voisins, non alimenté en mode de transmission ; le couplage mutuel élevé induit toujours une perte de rendement dans les antennes de type réseau. A titre d'exemple, les parois internes des logements 21 peuvent être métallisées avec un dépôt de cuivre.

La paroi latérale extérieure 23 du corps isolant 20 peut également être recouverte par un blindage conducteur fendu dans le sens de la longueur de l'antenne afin d'éviter la formation d'un courant induit par le fonctionnement des aimants de gradient de l'appareil d'IRM.

Les résonateurs 100 sont modulaires à l'intérieur des logements 21 du corps isolant 20. Ils sont introduits simplement par coulissement à l'intérieur des logements 21. Afin d'assurer la stabilité mécanique des résonateurs 100 en position dans le corps isolant 20, une couronne ajourée (non représentée) peut être fixée sur ce dernier au moyen de boulons amagnétiques.

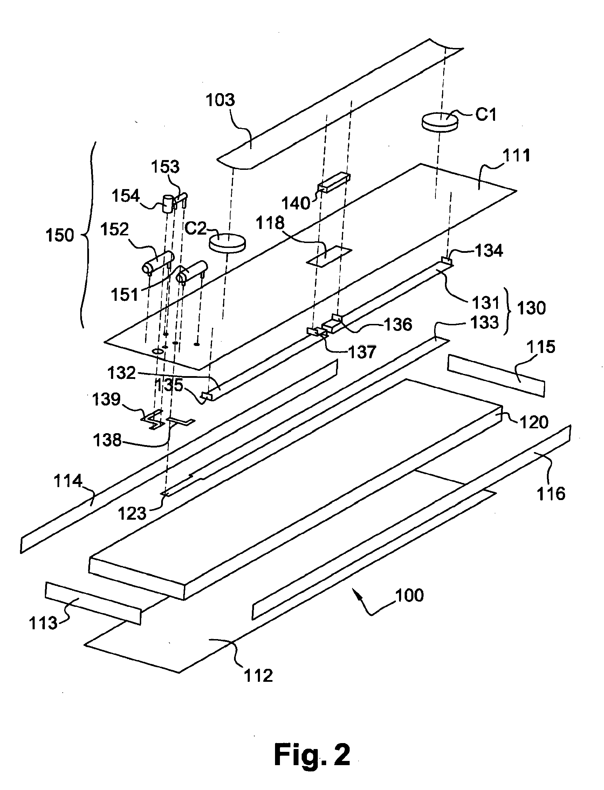

La figure 2 et la figure 3 illustrent de façon plus détaillée un premier mode de réalisation du résonateur 100 illustré à la figure 1.

Le figure 2 représente plus particulièrement une vue éclatée du résonateur 100 alors que la figure 3 illustre plus particulièrement une vue du résonateur assemblé et comportant une coupe partielle longitudinale.

Le résonateur 100 est formé par :

- un élément rayonnant 103 ;
- deux éléments capacitifs C1, C2 ;
- un substrat 120 ;
- une pluralité de plans de masse 111, 112, 113, 114, 115, 116 ;
- un circuit balun 130.

Dans ce premier mode de réalisation, l'élément rayonnant 103 est formé par une pièce droite de forme sensiblement rectiligne en matériau conducteur, avantageusement en cuivre, comportant une section en forme de U très ouvert. Toutefois, l'élément rayonnant 103 peut être formé par une pièce rectiligne comportant une section rectangulaire.

La forme en U très ouvert de l'élément rayonnant 103 permet d'augmenter sa rigidité mécanique et sa performance. La forme rectangulaire permet d'obtenir en revanche une conception simplifiée du résonateur selon l'invention.

L'élément rayonnant 103 est brasé, ou soudé, sur la face supérieure des deux éléments capacitifs C1, C2 en forme de pastille, rendus conducteurs par dépôt d'une couche métallique de cuivre, ou par collage d'un mince disque métallique (non représenté) sur la partie supérieure et éventuellement sur la partie inférieure des pastilles capacitives C1, C2. Les pastilles capacitives C1, C2 sont avantageusement rendues conductrices par un dépôt ou un collage de cuivre.

Les pastilles capacitives C1, C2 sont réalisées dans un matériau diélectrique de grande pureté, c'est-à-dire présentant au moins 96% en poids du matériau, afin de garantir de faibles pertes. A titre d'exemple, le matériau diélectrique des pastilles C1, C2 est un matériau céramique, tel que l'alumine présentant une pureté au moins égale à 96% en poids.

Les deux pastilles capacitives C1, C2 forment deux capacités dont les valeurs sont déterminées en fonction de la longueur de l'élément rayonnant 103 et en fonction de la fréquence de fonctionnement de l'appareil d'IRM en vue d'obtenir une résonance.

Les deux pastilles capacitives C1, C2 sont solidaires d'un plan de masse supérieur 111 par brasage ou encore soudage.

Le résonateur 100 comporte une pluralité de plans masse formée par la combinaison du plan de masse principal 111 supérieur recouvrant la face supérieur du substrat et de plans de masse secondaires 112, 113, 114, 115, 116 recouvrant les autres faces du substrat 120. Les plans de masse formant ainsi une continuité électrique. Le substrat 120 est réalisé dans un matériau diélectrique tel qu'un matériau composite, par exemple en Verre-Téflon. Les plans de masse 111, 112, 113, 114, 115, 116 peuvent être réalisés par un dépôt métallique sur le substrat 120 ou encore par collage de rubans conducteurs sur le substrat 120, idéalement en cuivre.

Le résonateur 100 comporte un circuit balun 130 reliant l'élément rayonnant 103 et l'embase coaxiale 154 de type SMA, l'embase coaxiale constituant l'interface électrique unique du résonateur 100 avec le monde extérieur.

Le circuit balun 130 est un circuit électrique largement utilisé dans le domaine des antennes pour effectuer une liaison entre une ligne de transmission symétrique, ou équilibrée, non reliée à la masse, c'est-à-dire l'élément rayonnant 103, et une ligne de transmission asymétrique, c'est-à-dire l'embase coaxiale 154 dont le connecteur externe est relié au plan de masse supérieur 111.

Le circuit balun 130 est formé par une ligne d'alimentation 133 et par deux lignes de couplage en miroir 131 et 132 qui sont enterrées dans le substrat 120 comme le montre la coupe longitudinale du substrat 120 de la figure 3, la ligne d'alimentation 133 et les deux lignes de couplages en miroir 131, 132 étant séparées par le substrat 120 et ne présentant pas de contact électrique entre elles. La transmission de puissance entre la ligne d'alimentation 133 recevant le signal modulé et les lignes de couplage est réalisée par couplage électromagnétique de proximité.

Le circuit balun 130 enterré dans le substrat 120 est obtenu par une superposition de plusieurs couches de substrat, typiquement de trois couches, solidarisées ensemble. Chacune des couches de substrat, formée par un matériau à faible perte, comporte une partie du circuit balun 130, le circuit balun 130 étant construit par la superposition des différentes couches de substrat sur lesquelles une partie du circuit est imprimée directement sur le substrat ou déposée.

Les extrémités 134 et 135 des lignes de couplage 131, 132 sont en contact avec le plan de masse principal 111 tandis que les deux contacts centraux 136 et 137 débouchant du substrat 120 forment des points de contact entre l'élément rayonnant 103 et le circuit balun 130. Les points de contact sont avantageusement positionnés symétriquement par rapport au centre de l'élément rayonnant 103. A cet effet, il est prévu une ouverture 118 de forme rectangulaire dans le plan de masse principal 111 pour le passage des contacts centraux 136, 137 débouchant du substrat. Cette ouverture 118 est dimensionnée avantageusement de façon à assurer une isolation d'au moins 1 mm entre les contacts centraux 136, 137 et le plan de masse principal 111.

Selon un autre mode de réalisation, les points de contact peuvent également être positionnés de façon asymétrique par rapport au centre de l'élément rayonnant 103.

Une pièce de connexion centrale 140 est solidaire de l'élément rayonnant 103, des contacts centraux 136, 137 et du substrat 120, par exemple par collage. Cette pièce de connexion centrale 140 n'assure qu'un renfort mécanique entre l'élément rayonnant 103 et le substrat 120. Elle peut être réalisée par exemple dans le même matériau que celui des pastilles capacitives C1, C2, c'est-à-dire en alumine de pureté au moins égale à 96% en poids. Avantageusement, la pièce de connexion centrale 140 est positionnée dans l'espace séparant les deux contacts centraux 136, 137.

L'adaptation en impédance (« matching ») du résonateur 103 est réalisée principalement par le choix de la distance entre les contacts centraux 136 et 137 des deux lignes de couplage miroir 131, 132 sur l'élément rayonnant 103, autrement dit par la longueur de la pièce centrale 140. Ainsi, les surtensions sont minimisées ce qui permet d'éviter une dissipation indésirable de puissance. Le choix du matériau du substrat 120 utilisé pour le circuit balun permet également de faire de varier le « matching ». De plus, la variation des dimensions de la ligne d'alimentation 133 et des deux lignes de couplage 131, 132 permet également de faire varier l'adaptation d'impédance du résonateur 100.

Ainsi, la distance entre les contacts centraux 136, 137 sera définie en fonction du type de charge introduite dans l'antenne permettant ainsi d'adapter l'adaptation d'impédance en fonction de la charge utile.

Avantageusement, dans une application IRM et pour une charge correspondant à une tête humaine, la distance entre les contacts centraux 136, 137 est de l'ordre de 3 à 4 cm.

Néanmoins, pour répondre à la variabilité en forme et en volume des têtes humaines le résonateur 100 selon l'invention comporte un circuit de réglage en fréquence (« tuning ») et d'adaptation d'impédance (« matching ») permettant d'adapter plus précisément l'antenne en fonction de la charge ou de l'échantillon analysé(e).

Le circuit de réglage 150 est formé par un circuit en $\pi$ composé par :

- deux capacités variables 151, 152,
- une inductance 153,
- des pistes de connexion 138, 139 noyées dans le substrat 120.

Le circuit de réglage 150 est positionné entre le circuit balun 130 et l'embase coaxiale 154 de type SMA constituant l'interface électrique unique du résonateur 100 avec le monde extérieur. Les deux ports du circuit de réglage 150 sont connectés respectivement à l'extrémité étroite 123 de la ligne d'alimentation 133 et à l'embase coaxiale 154 de type SMA.

La piste de connexion 138 relie l'inductance 153 et la capacité variable 151 alors que la piste de connexion 139 relie l'inductance 153, une embase coaxiale 154, et la deuxième capacité variable 152.

Grâce à la structure particulière du résonateur 100 et au circuit balun 130 enterré dans le substrat 120, le circuit en $\pi$ 150 est avantageusement déporté de l'élément rayonnant 103 et placé à une distance arbitraire, suffisamment éloigné de celui-ci, pour minimiser les interactions par rayonnement et les variations d'adaptation d'impédance par « effet de main » lors du réglage de l'adaptation d'impédance par l'opérateur. Typiquement, le circuit en $\pi$ 150 est positionné à l'extrémité arrière du résonateur 100, c'est-à-dire du coté opposé à l'extrémité introduite dans les logements 21 du corps isolant 20.

De plus, cette disposition éloignée de l'élément rayonnant 103 facilite grandement l'accès de l'opérateur aux éléments de réglages du résonateur 100. En effet, une fois les résonateurs 100 en place dans le corps isolant 20, les éléments de réglages restent facilement accessibles, permettant un réglage facile et rapide des résonateurs.

Les réglages de fréquence et d'adaptation d'impédance se réalisent simplement par modification de la position de l'axe central des capacités variables 151, 152. L'axe central forme la seconde électrode de la capacité et est relié à la masse commune formé notamment par le plan de masse supérieur 111 du résonateur 100. A titre d'exemple, le réglage par rotation de l'axe central peut être réalisé au moyen d'un tournevis en céramique de sorte que les « effets de main » sont encore minimisés.

Une fois les résonateurs 100 placés dans le corps isolant 20, l'ensemble des résonateurs 100 ont leur masse commune reliée entre elle afin d'éviter la formation de modes de type cavité ou volumiques parasites couplant les résonateurs.

Avantageusement, les pistes connexion 138, 139, la ligne d'alimentation 133 et les lignes de couplages 131, 132 sont réalisés en cuivre.

Dans ce premier mode de réalisation de l'invention, l'élément rayonnant 103 et le plan de masse supérieur 111 sont séparés par un diélectrique formé par l'air permettant ainsi de minimiser les pertes et d'augmenter le rendement en rayonnement des résonateurs 100. Toutefois, cette lame d'air dont l'épaisseur est déterminée par l'épaisseur des pastilles capacitives C1, C2, et avantageusement de l'ordre de quelques millimètres, pourrait rendre la fréquence de résonance du résonateur sensible à la variation de la constante diélectrique de l'air qui varie en fonction de l'humidité de l'air. Pour évaluer cette sensibilité, on peut considérer au premier ordre que la fréquence de résonance angulaire $\omega_0$ du résonateur 100 est donnée par la relation : $\omega_0 = \dfrac{1}{\left(C_T \cdot L\right)^{1/2}}$ ;

C$_T$ étant la capacité totale correspondant à la somme de la capacité formée entre l'élément rayonnant 103 et le plan de masse 111, soit C3, et des deux capacités C1, C2 formées par les pastilles capacitives ;
L représentant l'inductance du résonateur 103.

Par calcul différentiel, on démontre que :

$$\left(d\omega_0 / \omega_0\right) = -0,5\left(dC_T / C_T\right) = -0,5\left(C_3 / C_T\right)\cdot\left(d\varepsilon_{ra} / \varepsilon_{ra}\right) \; ;$$

où $\varepsilon_{ra}$ est la permittivité relative à l'air.

La valeur $d\varepsilon_{ra}$ pour l'air saturé en vapeur d'eau, c'est-à-dire le pire cas envisageable, à 30°C vaut 4.10$^{-4}$. Ainsi, à titre d'exemple, pour une capacité C3 de 17pF et une capacité totale C$_T$ de l'ordre de 49 pF, la dérive de fréquence due à l'humidité de l'air ne varie que de l'ordre de 20 kHz ce qui est très faible devant une résonance supérieure à 200 MHz et une bande passante de l'ordre de 1 MHz à -10dB.

Enfin, il est important qu'une poche d'air soit aménagée entre l'élément rayonnant 103 et les parois internes des logements 21 pour chaque résonateur 100 en place dans le corps de l'antenne 10. L'épaisseur de la poche d'air délimitée par la proximité des parois des logements 21 permet ainsi de moduler le couplage mutuel entre les résonateurs 100.

On notera que si les parois internes des logements 21 ne sont pas métallisées, alors les parois internes doivent être au moins à une distance équivalente à 2 millimètres de l'élément rayonnant 103. Dans le cas de figure où les parois internes des logements 21 sont métallisées alors les parois internes doivent être à une distance plus importante que dans le cas où les parois internes ne sont pas métallisées, c'est-à-dire typiquement à une distance de l'ordre de 6 millimètres.

Un exemple de réalisation d'un résonateur, selon le premier mode de réalisation décrit aux figures 2 et 3, va être présenté pour une antenne d'IRM 7 Tesla à huit voies, le résonateur 100 opérant donc à une fréquence proche de 298 MHz, dépendante de la valeur effective, mesurée de $B_0$.

Dans cet exemple de réalisation, le corps isolant 20 de l'antenne est de forme cylindrique de diamètre interne de 250 mm et de diamètre externe de 317 mm. Le corps isolant 20 comporte autant de logements 21 que de résonateurs 100, c'est-à-dire huit.

Chacun des huit résonateurs est formé par :

- un élément rayonnant 103 formé par une lame de cuivre de 1 mm d'épaisseur, pliée en forme de U très ouvert d'une longueur de 260 mm, d'une largeur de 24 mm et d'une hauteur de 3 mm et formant une capacité de l'ordre de 17 pF ;
- deux pastilles capacitives C1, C2 en alumine de pureté au moins égale à 96% en poids, d'un diamètre de 24 mm et d'une épaisseur de 3,18 mm, ayant une capacité de l'ordre de 16 pF ;
- un substrat 120 en verre-téflon d'une longueur de 370 mm, d'une largeur de 70 mm et d'une hauteur de 9,54 mm ;
- une pluralité de plans de masse 111, 112, 113, 114, 115, 116 réalisés par des rubans en cuivre de 18 $\mu$m d'épaisseur recouvrant chaque face du substrat en verre-téflon ;
- une ligne d'alimentation 133 formée par un ruban en cuivre de 18 $\mu$m d'épaisseur noyé dans le substrat, d'une longueur de 318 mm et d'une largeur de 10 mm ;
- deux lignes de couplage 131, 132 formées par des rubans en cuivre de 18 $\mu$m d'épaisseur noyés dans le substrat 120, d'une longueur de 140 mm, d'une largeur de 10 mm et d'une hauteur de 6,36 mm ;
- un élément de connexion central 140, solidaire de l'élément rayonnant 103 et des contacts centraux 136, 137 des lignes de couplage 131, 132, formé par une tablette rectangulaire en alumine de pureté au moins égale à 96% en poids d'une longueur de 40 mm, d'une largeur de 7 mm et d'une hauteur de 3,18 mm.
- des pistes de connexion 138, 139 réalisées en cuivre de 18 $\mu$m d'épaisseur ;
- deux capacités 151, 152 variables entre 1 et 10pF ;
- une inductance 153 bobinée à air de 22nH ;
- un connecteur coaxial 154 de type SMA non magnétique.

La conception et l'optimisation de l'antenne 10 sont réalisées en se basant sur l'utilisation de la simulation numérique avec un code HFSS (Méthode des Eléments Finis) de la société Ansoft connu dans le domaine de l'imagerie par résonance magnétique nucléaire. Lors de la simulation, la tête du patient est représentée par un modèle numérique, dit fantôme anatomique, fourni par la société Aarkid, North Berwick, Scotland pour les simulations HFSS. Le modèle anatomique 200 est composé de huit types de tissus organiques correspondant aux différents éléments anatomiques de la tête : muscles, boîte crânienne, mâchoire, lobes latéraux, cervelet, langue, moelle épinière, yeux.

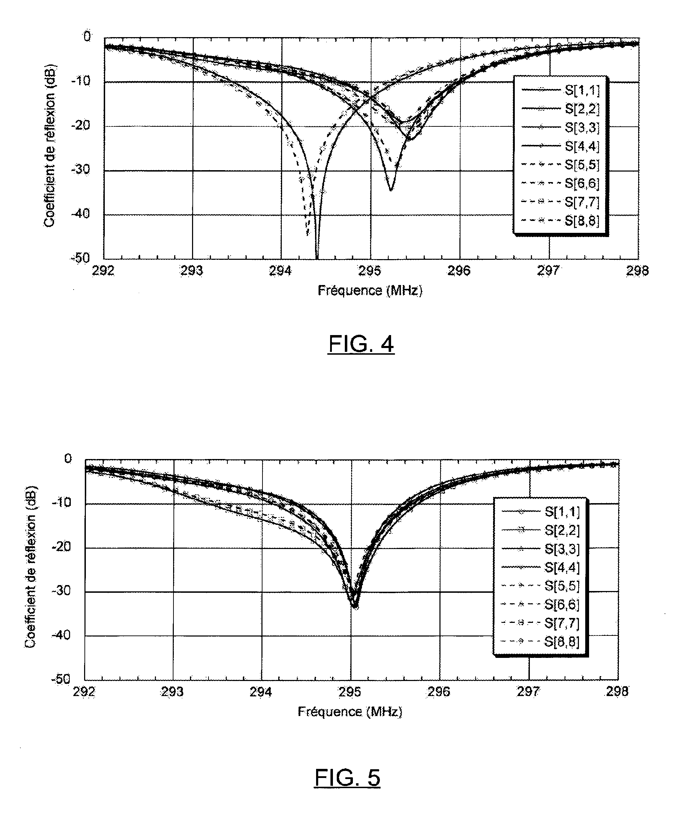

La figure 4 illustre les résultats de la simulation sous la forme d'un graphique représentant la fréquence de résonance de chaque résonateur linéaire 100 de l'antenne 10 illustré à la figure 1 avant le paramétrage du circuit « tuning » et du circuit « matching ».

D'après cette simulation, on remarque que sans réglage de la fréquence et de l'adaptation d'impédance au moyen du circuit en $\pi$ 150 de réglage, chacun des résonateurs linéaires 100 résonne à une fréquence différente et légèrement décalée de la fréquence de travail malgré une construction identique des résonateurs. Ce décalage résulte du fait de l'influence de la charge introduite dans l'antenne. En numérotant les résonateurs 100 de l'antenne 10 de R1 à R8 à partir du résonateur situé en haut à gauche de la lumière 22 dans le corps isolant 20 de l'antenne 10, on constate néanmoins une symétrie nette entre les résonateurs R1 et R8, R2 et R7, ainsi de suite. La symétrie des signaux reflète la symétrie miroir du fantôme par rapport au plan sagittal.

Grâce au circuit en $\pi$ 150 des résonateurs 100 selon l'invention, il est possible de régler parfaitement les différents résonateurs 100 afin de les faire fonctionner à une même fréquence de résonance avec une très bonne adaptation en impédance. A cet effet, la figure 5 illustre la fréquence de résonance de chaque résonateur 100 de l'antenne 10 après paramétrage de la fréquence de résonance et d'adaptation d'impédance au moyen du circuit en $\pi$ 150. On rappelle, que le circuit en $\pi$ 150 du résonateur 100 est facile d'accès ce qui permet à l'opérateur de pouvoir homogénéiser rapidement et de façon simple la fréquence de résonance et l'adaptation d'impédance des résonateurs 100 en fonction de la charge introduite dans l'antenne.

Afin de prédire les performances d'une antenne réseau, il est nécessaire d'établir une cartographie de la distribution de la composante magnétique d'excitation dans un repère tournant à la fréquence de Larmor $B_1^+$ du champ radiofréquence rayonné par chaque résonateur lorsque la charge est positionnée dans l'antenne. Cette cartographie de $B_1^+$ peut être réalisée par simulation à partir de la composante magnétique $B_1$ du champ radiofréquence d'excitation ou directement par mesure sur un prototype dans un scanner IRM.

La simulation est effectuée au moyen du logiciel de simulation numérique HFSS de la société Ansoft. Le principe de la simulation consiste à étudier systématiquement la distribution de la composante magnétique $B_1$ telle que :

$$B_1 = \begin{vmatrix} B_{1x} \\ B_{1y} \end{vmatrix},$$

les indices « x » et « y » se réfèrent à un repère cartésien fixe, lié au laboratoire, selon les axes X et Y (non représentés) perpendiculaire à l'axe longitudinal Z de l'antenne (non représenté), l'axe longitudinal Z étant la direction de l'aimantation globale du champ $B_0$.

La simulation du champ magnétique $B_1$ permet de déduire $B_1^+$ au moyen d'un calcul intermédiaire, $B_1^+$ correspondant au phaseur du champ magnétique $B_1$ décomposé dans un repère tournant dans le même sens des spins selon la relation :

$$B_1^+ = \vec{B}_1 \cdot \vec{e}_{LHCP}$$

où

$$\vec{e}_{LHCP} = \frac{1}{\sqrt{2}} \begin{vmatrix} 1 \\ j \end{vmatrix}$$

La détermination de la cartographie représentant la distribution du champ magnétique $B_1^+$ peut également être réalisée expérimentalement par mesure à partir d'un prototype. Pour cela, il suffit de déterminer directement la cartographie de la composante magnétique B; , notamment au moyen d'une méthode d'acquisition, dite méthode AFI (pour Actual Flip-angle Imaging en langue anglaise) [Vasily L. Yarnykh, Actual Flip-angle Imaging in the Pulsed Steady State. Magn Reson Led 2007 ; 57 : 192-200] connue du domaine de l'imagerie médicale.

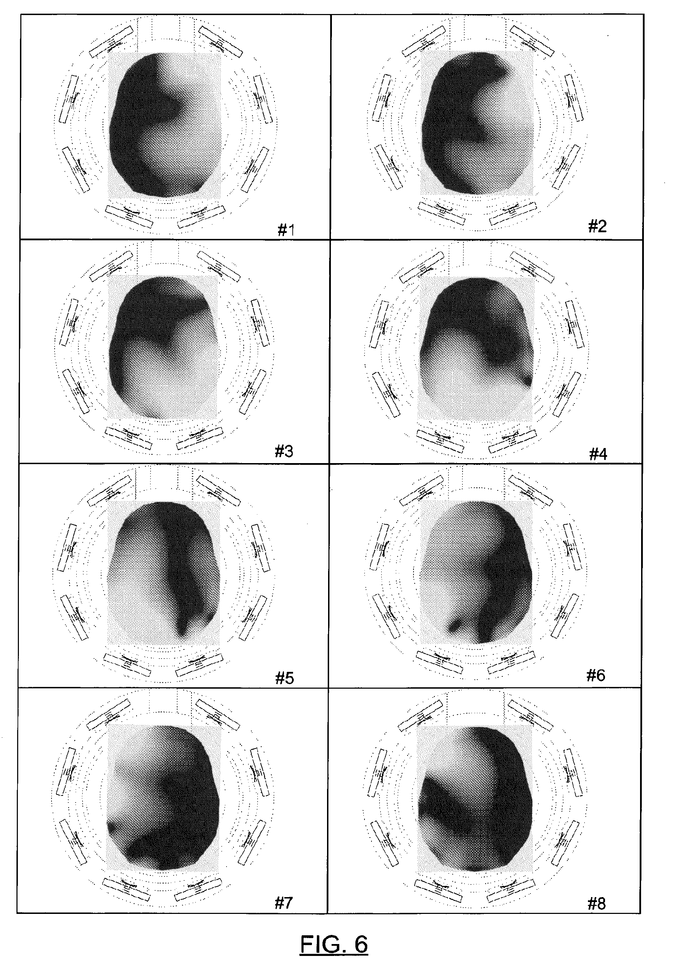

La figure 6 représente, pour une antenne 7 Tesla à huit voies comportant des résonateurs 100 définis précédemment, la carte du champ rayonné $B_1^+$ pour chaque résonateur R1 à R8 visible par la charge introduite (i.e. le fantôme anatomique dans notre cas).

L'échelle de la distribution correspond à une variation de 0 à $4\mu T$, obtenue pour une puissance incidente de 100W.

Grâce aux résonateurs selon l'invention, l'antenne permet de réduire les artéfacts d'intensité de l'image 3D, notamment au niveau des lobes latéraux et du cervelet. Les artefacts sont réduits à 7% avec l'exemple de réalisation décrit précédemment.

De façon à obtenir un résultat optimum, l'antenne 10 et les résonateurs 100 sont pilotés au moyen de la technique de transmission parallèle utilisant la recombinaison de deux images obtenues consécutivement à deux impulsions d'excitation complémentaire. Cette technique connue permet en particulier d'homogénéiser l'excitation dans une région d'intérêt choisie, dite zone ROI (pour « Region Of Interest » en langue anglaise). Pour un angle de bascule équivalent à 20 degrés et une durée d'impulsion d'une milliseconde, les puissances et les phases appliquées à chaque résonateur sont données à titre d'exemple dans le tableau suivant :

| | Première impulsion | | Seconde impulsion | |
|---|---|---|---|---|
| voie | Puissance (Watt) | Phase (degrés) | Puissance (Watt) | Phase (degrés) |
| R1 | 6.84 | -1.1 | 2.48 | -164.7 |
| R2 | 15.1 | 13.4 | 1.43 | -151.3 |

(suite)

| voie | Première impulsion | | Seconde impulsion | |
| --- | --- | --- | --- | --- |
| | Puissance (Watt) | Phase (degrés) | Puissance (Watt) | Phase (degrés) |
| R3 | 13.1 | 29.3 | 1.12 | 70.3 |
| R4 | 9.56 | 25.2 | 2.85 | 71.8 |
| R5 | 7.30 | 45.6 | 1.28 | 45.4 |
| R6 | 8.53 | 42.8 | 3.01 | -4.3 |
| R7 | 8.36 | 49.4 | 9.20 | -88.9 |
| R8 | 3.40 | 81.3 | 19.8 | -92.0 |

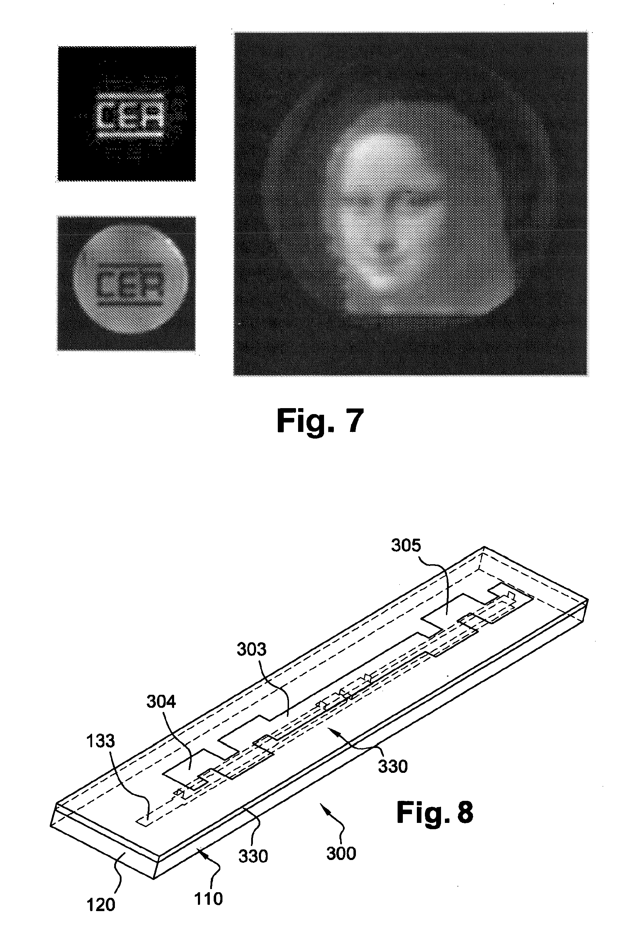

La figure 7 illustre des exemples d'imageries obtenues avec l'antenne telle que décrite dans l'exemple de réalisation au moyen d'un procédé de transmission dite de l'imagerie sélective, décrite par J. Pauly et al (Journal of Magnetic Resonance 81 : 43-46, 1989). Ce procédé consiste à inscrire un motif prédéterminé à l'intérieur d'un fantôme homogène, en l'occurrence, un ballon en verre rempli de solution saline.

La figure 8 est une variante des figures 2, 3 précédentes, les moyens en commun entre les dispositifs 100 et 300 portent les mêmes numéros de référence et réalisent les mêmes fonctions. On ne décrira par conséquent que les caractéristiques différentes entre ces deux modes de réalisation.

Le résonateur 300 selon ce second mode de réalisation se différencie du résonateur 100 des figures 1, 2, et 3 en ce qu'il comporte un élément rayonnant 303 plan intégré dans une plaque 330 de substrat solidaire du substrat 120.

Typiquement, dans ce deuxième mode de réalisation, le diélectrique formé par l'air dans le résonateur 100 est remplacé par la plaque 330 de matériau diélectrique.

Dans ce deuxième mode de réalisation, les pastilles capacitives en céramiques et l'élément rayonnant en forme de U très ouvert sont supprimées et remplacées par la plaque 330 de substrat, typiquement de même matériau que celui utilisé pour le substrat du circuit balun 130. La plaque 330 comporte sur sa face supérieure une large piste métallisée 303 gravée directement sur la plaque 330 faisant office d'élément rayonnant.

L'élément rayonnant 303 comporte au niveau de ses extrémités une forme spécifique formée par des méandres 304, 305 permettant de faire résonner l'élément rayonnant 303 en l'absence des capacités en céramique.

On notera que la forme des méandres 304, 305 est étudiée en fonction de la fréquence de résonance voulue du résonateur 303.

La plaque 330 comporte une ouverture centrale (non visible sur la figure 8) permettant aux contacts centraux du circuit balun 130 de venir en contact avec l'élément rayonnant 303.

Cette plaque 330 comporte une dimension inférieure au substrat 120 de sorte que la plaque 330 ne recouvre pas le plan de masse supérieur 111 au niveau de l'emplacement des capacités variables et de l'inductance du circuit de réglage en $\pi$ (non représentées).

Ce deuxième mode de réalisation permet d'obtenir un résonateur 300 plus rigide et plus compact que le premier mode de réalisation. Cependant, les performances obtenues par le premier mode de réalisation illustré aux figures 2 et 3 sont supérieures aux performances obtenues par ce deuxième mode de réalisation.

Ainsi, grâce à l'invention, la structure de l'élément rayonnant portée par deux capacités intégrées de très faible perte et capable d'opérer à des puissances de crêtes élevées permet d'adapter sa longueur en fonction des besoins dans une plage de fréquence de 200MHz à 600MHz. La disposition des résonateurs dans le corps isolant de l'antenne est choisie de manière à faciliter l'uniformisation de l'excitation par les méthodes de transmission parallèle et surtout à minimiser le dépôt local de puissance des tissus. Elle autorise également l'intégration de blindage de façon à réduire le couplage mutuel des résonateurs.

De plus, un nombre fini de résonateurs linéaires peuvent être regroupés entre eux pour former une mini-antenne, de type fonctionnant en mode volumique, intégrée dans un réseau de résonateurs indépendants de même type. Cette configuration est permise par la structure des résonateurs modulaires et apporte une économie sur le nombre de canaux électroniques de pilotage et sur le nombre d'amplificateurs nécessaires pour l'alimentation de l'antenne tout en offrant une grande flexibilité du point de vue de la transmission parallèle.

Enfin, les résonateurs peuvent être dimensionnés de longueurs différentes, regroupés entre eux par longueur et disposés à des positions particulières dans la direction longitudinale, c'est-à-dire selon l'axe du patient, et dans la direction radiale.

L'invention a été particulièrement décrite pour une utilisation en imagerie par résonance magnétique nucléaire ; toutefois, l'invention est également applicable au domaine de la spectroscopie par résonance magnétique (SRM).

**EP 2 534 499 B1**

**Revendications**

1. Résonateur linéaire (100, 300) d'une antenne haute fréquence (10) apte à émettre un signal radiofréquence d'excitation et à recevoir un signal radiofréquence de relaxation, ledit résonateur linéaire (100, 300) comportant :

   - un élément rayonnant (103, 303) apte à émettre un signal radio fréquence d'excitation et à recevoir un signal radiofréquence de relaxation,
   - un circuit balun (130), et
   - un substrat (120), formé par un matériau diélectrique, supportant ledit élément rayonnant (103, 303) et dans lequel ledit circuit balun (130) est incorporé,

   ledit résonateur étant **caractérisé en ce que** :

   - ledit circuit balun (130) est formé par une ligne d'alimentation (133) et par deux lignes de couplage (131, 132) ;

   et en ce que le résonateur comporte :

   - deux points de contacts (136, 137) reliant ledit circuit balun (130) au dit élément rayonnant (103, 303), lesdits points de contacts étant formés par l'une des extrémités desdites lignes de couplage (131, 132) débouchant dudit substrat (120), la distance séparant les deux points de contact (136, 137) étant choisie lors de la conception dudit résonateur de façon à assurer l'adaptation d'impédance dudit résonateur (100, 300) ;
   - un plan de masse (111) séparant lesdites lignes de couplage (131, 132) dudit élément rayonnant (103, 303).

2. Résonateur linéaire (100, 300) selon la revendication précédente **caractérisé en ce que** ledit résonateur (100, 300) comporte des moyens de réglage (150) pour ajuster l'adaptation d'impédance et la fréquence de résonance dudit résonateur (100, 300).

3. Résonateur linéaire (100, 300) selon la revendication 2 **caractérisé en ce que** lesdits moyens de réglage (150) sont connectés audit circuit balun (130) et sont disposés à une distance dudit élément rayonnant (103, 303) telle qu'une opération de réglage par un opérateur n'affecte ni l'adaptation d'impédance ni la fréquence de résonance dudit élément rayonnant (103, 303).

4. Résonateur linéaire (100, 300) selon les revendications 2 et 3 **caractérisé en ce que** lesdits moyens de réglage (150) sont formés par un circuit en $\pi$ tel qu'un circuit en $\pi$ comportant deux capacités variables (151, 152) et une inductance (153).

5. Résonateur linéaire (100, 300) selon l'une des revendications 1 à 4 **caractérisé en ce que** ledit résonateur comporte une pluralité de plans de masse (111, 112, 113, 114, 115, 116) recouvrant chaque face dudit substrat (120), ladite pluralité de plans de masse comportant au moins un plan de masse principal supérieur (111) recouvrant la partie supérieure dudit substrat (120).

6. Résonateur linéaire (100) selon la revendication 5 **caractérisé en ce que** ledit élément rayonnant (103) est brasé ou soudé sur deux capacités céramiques (C1, C2) brasées ou soudées sur ledit plan de masse supérieur (111).

7. Résonateur linéaire (100) selon la revendication 6 **caractérisé en ce que** lesdites capacités céramiques (C1, C2) sont des capacités présentant un facteur de qualité supérieur à 1000.

8. Résonateur linéaire (100) selon l'une des revendications 6 à 7 **caractérisé en ce que** lesdites capacités céramiques (C1, C2) sont réalisées en alumine dont la pureté est au moins égale à 96% en poids.

9. Résonateur linéaire (100) selon l'une des revendications 6 à 8 **caractérisé en ce que** les valeurs desdites capacités (C1, C2) sont choisies de sorte qu'elles déterminent la fréquence de résonance dudit résonateur (103).

10. Résonateur linéaire (100) selon l'une des revendications 6 à 9 **caractérisé en ce que** ledit élément rayonnant (103) est formé par un élément conducteur dont la section présente une forme en U ouvert.

11. Résonateur linéaire (100) selon l'une des revendications 6 à 9 **caractérisé en ce que** ledit élément rayonnant (103) est formé par un élément conducteur dont la section présente une forme rectangulaire.

**12.** Résonateur linéaire (300) selon la revendication 5 **caractérisé en ce que** ledit élément rayonnant (303) est formé par une piste imprimée sur une couche de substrat diélectrique (330) solidarisée sur ledit plan de masse supérieur (111).

**13.** Résonateur linéaire (300) selon la revendication 12 **caractérisé en ce que** ledit élément rayonnant (303) comporte des méandres (304, 305) au niveau de ses extrémités.

**14.** Résonateur linéaire (300) selon la revendication 13 **caractérisé en ce que** la forme des méandres (304, 305) est telle qu'elle détermine la fréquence de résonance dudit résonateur (300).

**15.** Antenne (10) haute fréquence pour appareil de résonance magnétique nucléaire comportant un corps isolant (20) et une pluralité de résonateurs linéaires selon l'une des revendications 1 à 14 **caractérisée en ce que** lesdits résonateurs (100, 300) sont montés amovibles dans des logements (21) dudit corps isolant (20) de ladite antenne (10).

**16.** Antenne (10) selon la revendication 15 **caractérisée en ce qu'**elle comporte une couronne amovible apte à maintenir en position lesdits résonateurs (100, 300) dans leur logement respectif (21).

**17.** Antenne (10) selon l'une des revendications 15 à 16 **caractérisée en ce que** lesdites parois internes desdits logements (21), exceptée celle en regard de l'élément rayonnant 103, 303), sont métallisées de façon à isoler chaque résonateur (100, 300).

**18.** Antenne (10) selon l'une des revendications 15 à 17 **caractérisée en ce que** lesdits logements (21) sont dimensionnés de façon à former une poche d'air autour de chaque élément rayonnant (103, 303) de chaque résonateur (100, 300) en position dans ledit corps isolant (20).

**19.** Antenne (10) selon l'une des revendications 15 à 18 **caractérisée en ce qu'**elle comporte un blindage sur la paroi externe (23) dudit corps isolant (20).

**Patentansprüche**

**1.** Linearer Resonator (100, 300) einer Hochfrequenzantenne (10), der geeignet ist, ein Erregungs-Funkfrequenzsignal zu senden und ein Entspannungs-Funkfrequenzsignal zu empfangen, wobei der genannte lineare Resonator (100, 300) umfasst:

- ein ausstrahlendes Element (103, 303), das geeignet ist, ein Erregungs-Funkfrequenzsignal zu senden und ein Entspannungs-Funkfrequenzsignal zu empfangen,
- eine Balunschaltung (130) und
- ein Substrat (120), das durch ein dieleketrisches Material gebildet ist und das genannte ausstrahlende Element (103, 303) zu stützen und in dem die genannte Balunschaltung (130) integriert ist,

wobei der genannte Resonator **dadurch gekennzeichnet** ist, dass:

- die genannte Balunschaltung (130) durch eine Versorgungsleitung (133) und durch zwei Kopplungsleitungen (131, 132) gebildet ist;

und dass der Resonator umfasst:

- zwei Kontaktpunkte (136, 137), die die genannte Balunschaltung (130) an das genannte ausstrahlende Element (103, 303) anschließen, wobei die genannten Kontaktpunkte durch eines der Enden der genannten Kopplungslinien (131, 132) gebildet sind, die aus dem genannten Substrat (120) einmünden, wobei die die zwei Kontaktpunkte (136, 137) trennende Entfernung bei der Entwicklung des genannten Resonators derart gewählt sind, dass die Impedanzanpassung des genannten Resonators (100, 300) gewährleistet ist;
- eine Masseebene (111), die die genannten Kopplungsleitungen (131, 132) des genannten ausstrahlenden Elements (103, 303) trennt.

**2.** Linearer Resonator (100, 300) gemäß dem voranstehenden Anspruch, **dadurch gekennzeichnet, dass** der genannte Resonator (100, 300) Einstellmittel (150) zum Anpassen der Impedanzanpassung und der Resonanzfrequenz des genannten Resonators (100, 300) umfasst.

3. Linearer Resonator (100, 300) gemäß Anspruch 2, **dadurch gekennzeichnet, dass** die genannten Einstellmittel (150) an die genannte Balunschaltung (130) angeschlossen sind und entfernt von dem genannten ausstrahlenden Element (103, 303) derart angeordnet sind, dass eine Einstelloperation durch einen Operator weder die Impedanzanpassung noch die Resonanzfrequenz des genannten ausstrahlenden Elements (103, 303) beeinträchtigt.

4. Linearer Resonator (100, 300) gemäß Anspruch 2 und 3, **dadurch gekennzeichnet, dass** die genannten Einstellmittel (150) durch einen Schaltkreis in n gebildet sind, wie z. B. einen Schaltkreis in n, der zwei variable Kapazitäten (151, 152) und eine Induktanz (153) hat.

5. Linearer Resonator (100, 300) gemäß Anspruch 1 bis 4, **dadurch gekennzeichnet, dass** der genannte Resonator eine Vielzahl von Masseplänen (111, 112, 113, 114, 115, 116) umfasst, die jede Seite des genannten Substrats (120) abdecken, wobei die genannte Vielzahl von Masseplänen wenigstens eine Ebene der oberen Hauptmasse (111) umfasst, der den oberen Teil des genannten Substrats (120) abdeckt.

6. Linearer Resonator (100) gemäß Anspruch 5, **dadurch gekennzeichnet, dass** das genannte ausstrahlende Element (103) auf zwei Keramikkapazitäten (C1, C2) aufgelötet oder aufgeschweißt ist, die auf der genannten Ebene der oberen Hauptmasse (111) aufgelötet oder aufgeschweißt sind.

7. Linearer Resonator (100) gemäß Anspruch 6, **dadurch gekennzeichnet**, das die genannten Keramikkapazitäten (C1, C2) Kapazitäten sind, die einen höheren Qualitätsfaktor aufweisen als 1000.

8. Linearer Resonator (100) gemäß Anspruch 6 bis 7, **dadurch gekennzeichnet, dass** die genannten Keramikkapazitäten (C1, C2) aus Aluminiumoxid realisiert sind, deren Reinheit wenigstens gleich 96 Gew. % ist.

9. Linearer Resonator (100) gemäß Anspruch 6 bis 8, **dadurch gekennzeichnet, dass** die Werte der genannten Kapazitäten (C1, C2) derart ausgewählt sind, dass sie die Resonanzfrequenz des genannten Resonators (103) bestimmen.

10. Linearer Resonator (100) gemäß Anspruch 6 bis 9, **dadurch gekennzeichnet, dass** das genannte ausstrahlende Element (103) durch ein leitendes Element gebildet ist, dessen Querschnitt eine offene U-Form aufweist.

11. Linearer Resonator (100) gemäß Anspruch 6 bis 9, **dadurch gekennzeichnet, dass** das genannte ausstrahlende Element (103) durch ein leitendes Element gebildet ist, dessen Querschnitt eine rechteckige Form aufweist.

12. Linearer Resonator (300) gemäß Anspruch 5, **dadurch gekennzeichnet, dass** das genannte ausstrahlende Element (303) durch einen gedruckten Leiter auf einer dielektrischen Substratschicht (330) gebildet ist, die auf der genannten Ebene der oberen Masse (111) fest befestigt ist.

13. Linearer Resonator (300) gemäß Anspruch 12, **dadurch gekennzeichnet, dass** das genannte ausstrahlende Element (303) an seinen Enden Mäander (304, 305) umfasst.

14. Linearer Resonator (300) gemäß Anspruch 13, **dadurch gekennzeichnet, dass** die Form der Mäander (304, 305) derart ist, dass sie die Resonanzfrequenz des genannten Resonators (300) bestimmt.

15. Hochfrequenzantenne (10) für ein magnetisches, nukleares Resonanzgerät, umfassend einen isolierenden Körper (20) und eine Vielzahl von linearen Resonatoren gemäß Anspruch 1 bis 14, **dadurch gekennzeichnet, dass** die genannten Resonatoren (100, 300) abnehmbar in Aufnahmen (21) des genannten isolierenden Körpers (20) der genannten Antenne (10) montiert sind.

16. Antenne (10) gemäß Anspruch 15, **dadurch gekennzeichnet, dass** sie eine abnehmbare Krone umfasst, die geeignet ist, die genannten Resonatoren (100, 300) in ihrer jeweiligen Aufnahme (21) in Position zu halten.

17. Antenne (10) gemäß Anspruch 15 bis 16, **dadurch gekennzeichnet, dass** die genannten inneren Wände der genannten Aufnahmen (21) mit Ausnahme der, die dem ausstrahlenden Element (103, 303) gegenüberliegt, derart metallisiert sind, dass jeder Resonator (100, 300) isoliert ist.

**18.** Antenne (10) gemäß Anspruch 15 bis 17, **dadurch gekennzeichnet, dass** die genannten Aufnahmen (21) derart ausgelegt sind, dass sie einen Luftsack rund um jedes ausstrahlende Element (103, 303) jedes Resonators (100, 300) in der Position in dem genannten isolierenden Körper (20) bilden.

**19.** Antenne (10) gemäß Anspruch 15 bis 18, **dadurch gekennzeichnet, dass** sie eine Abschirmung auf der äußeren Wand (23) des genannten isolierenden Körpers (20) umfasst.

**Claims**

**1.** Linear resonator (100, 300) of a high frequency antenna (10) capable of emitting an excitation radio frequency signal and receiving a relaxation radio frequency signal, said linear resonator (100, 300) comprising:

- a radiating element (103, 303) capable of emitting an excitation radio frequency signal and receiving a relaxation radio frequency signal,
- a balun circuit (130) and
- a substrate (120) formed by a dielectric material supporting said radiating element (103, 303) and in which said balun circuit (130) is incorporated,

said resonator being **characterised in that**:

- said balun circuit (130) is formed by a power supply line (133) and two coupling lines (131, 132);

and in that the resonator comprises:

- two contact points (136, 137) connecting said balun circuit (130) to said radiating element (103, 303), said contact points being formed by one of the ends of said coupling lines (131, 132) opening up in said substrate (120), the distance separating the two contact points (136, 137) being chosen during the design of said resonator so as to match the impedance of said resonator (100, 300);
- a ground plane (111) separating said coupling lines (131, 132) from said radiating element (103, 303).

**2.** Linear resonator (100, 300) according to the previous claim, **characterised in that** said resonator (100, 300) comprises adjustment means (150) to adjust impedance matching and the resonant frequency of said resonator (100, 300)

**3.** Linear resonator (100, 300) according to claim 2, **characterised in that** said adjustment means (150) are connected to said balun circuit (130) and are located at a distance from said radiating element (103, 303) such that an adjustment operation by an operator does not affect impedance matching nor the resonant frequency of said radiating element (103, 303).

**4.** Linear resonator (100, 300) according to claims 2 and 3, **characterised in that** said adjustment means (150) are formed by a $\pi$ circuit such as a $\pi$ circuit comprising two variable capacitances (151, 152) and an inductance (153).

**5.** Linear resonator (100, 300) according to one of claims 1 to 4, **characterised in that** said resonator comprises a plurality of ground planes (111, 112, 113, 114, 115, 116) covering each face of said substrate (120), said plurality of ground planes comprising at least one upper main ground plane (111) covering the upper part of said substrate (120).

**6.** Linear resonator (100) according to claim 5, **characterised in that** said radiating element (103) is brazed or welded onto two ceramic capacitances (C1, C2) brazed or welded to said upper ground plane (111).

**7.** Linear resonator (100) according to claim 6, **characterised in that** said ceramic capacitances (C1, C2) are capacitances with a quality factor of more 1000.

**8.** Linear resonator (100) according to one of claims 6 to 7, **characterised in that** said ceramic capacitances (C1, C2) are made of alumina with a purity equal to at least 96% by weight.

**9.** Linear resonator (100) according to one of claims 6 to 8, **characterised in that** the values of said capacitances (C1, C2) are chosen such that they determine the resonant frequency of said resonator (103).

**10.** Linear resonator (100) according to one of claims 6 to 9, **characterised in that** said radiating element (103) is formed by a conducting element with an open U-shaped section.

**11.** Linear resonator (100) according to one of claims 6 to 9, **characterised in that** said radiating element (103) is formed by a conducting element with a rectangular-shaped section.

**12.** Linear resonator (300) according to claim 5, **characterised in that** said radiating element (303) is formed by a track printed on a layer of a dielectric substrate (330) fixed to said upper ground plane (111).

**13.** Linear resonator (300) according to claim 12, **characterised in that** said radiating element (303) comprises meanders (304, 305) at its ends.

**14.** Linear resonator (300) according to claim 13, **characterised in that** the shape of the meanders (304, 305) is such that it determines the resonant frequency of said resonator (300).

**15.** High frequency antenna (10) for a nuclear magnetic resonance instrument comprising an isolating body (20) and a plurality of linear resonators according to one of claims 1 to 14, **characterised in that** said resonators (100, 300) are mounted free to move in housings (21) in said isolating body (20) of said antenna (10).

**16.** Antenna (10) according to claim 15, **characterised in that** it comprises a removable ring capable of keeping said resonators (100, 300) in position in their corresponding housing (21).

**17.** Antenna (10) according to one of claims 15 to 16, **characterised in that** said internal walls of said housings (21) are metallised, except for the wall facing the radiating element (103, 303), so as to isolate each resonator (100, 300).

**18.** Antenna (10) according to one of claims 15 to 17, **characterised in that** said housings (21) are sized so as to form an air pocket around each radiating element (103, 303) of each resonator (100, 300) in position in said isolating body (20).

**19.** Antenna (10) according to one of claims 15 to 18, **characterised in that** it comprises a shielding on the external wall (23) of said isolating body (20).

**Fig. 1**

**Fig. 3**

**Fig. 2**

FIG. 4

FIG. 5

FIG. 6

**Fig. 7**

**Fig. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4746866 A, Röschmann
- US 4751464 A, Bridges
- US 5557247 A, Vaughn, Jr.
- US 20050062472 A, Bottomley

**Littérature non-brevet citée dans la description**

- **VAUGHN.** *Proc. Int. Soc. Mag. Res. Med.,* 2003, vol. 11 (2354
- **ADRIANY.** *Magnetic Resonance in Medicine,* 2005, vol. 53, 434445
- **SETSOMPOP.** *Magnetic Resonance in Medicine,* 2006, vol. 56, 11631171
- **VASILY L. YARNYKH.** Actual Flip-angle Imaging in the Pulsed Steady State. *Magn Reson Led,* 2007, vol. 57, 192-200
- **J. PAULY et al.** *Journal of Magnetic Resonance,* 1989, vol. 81, 43-46